# EUROPEAN PATENT APPLICATION

(11) **EP 1 624 494 A1**
(43) Date of publication of application: **08.02.2006**
(21) Application number: 04730025.6
(22) Date of filing: 28.04.2004
(51) Int. Cl.: H01L 31/04, H01B 5/14, C23C 16/40, B32B 9/00

(54) **TRANSPARENT CONDUCTIVE SUBSTRATE FOR SOLAR BATTERY AND METHOD FOR PRODUCING SAME**

(30) Priority: 13.05.2003 JP 2003134847
(71) Applicant: ASAHI GLASS COMPANY LTD., Tokyo 100-8405 (JP)
(72) Inventor: FUKAWA, Makoto, c/o Asahi Glass Company, Limited, Ichihara-shi, Chiba (JP); TANEDA, Naoki, c/o Asahi Glass Company, Limited, Yokohama-shi, Kanagawa 2218755 (JP); SATO, Kazuo, c/o Asahi Glass Company, Limited, Yokohama-shi, Kanagawa 2218755 (JP)
(74) Representative: Müller-Boré & Partner Patentanwälte
(86) International application number: PCT/JP2004/006130
(87) International publication number: WO 2004/102677

(57) **Abstract**

A transparent conductive substrate for solar cells having high haze ratio and little variation of the haze ratio over the entire substrate, and excellent in light transmittance, and the production process of the substrate are provided.

A transparent conductive substrate for solar cells comprising a substrate and a TiO₂ layer, a SiO₂ layer and a SnO₂ layer formed on the substrate in this order from the side of the substrate, wherein the thickness of the SnO₂ layer is from 0.5 to 0.9 µm and the illuminant C haze ratio is from 20 to 60%.

## Description

### TECHNICAL FIELD

The present invention relates to a transparent conductive substrate for solar cells and a method for producing the substrate.

### BACKGROUND ART

As solar cells of thin-film type, there are amorphous silicon type solar cells each having a photoelectric conversion layer constituted by an amorphous silicon layer, crystal silicon type solar cells each having a photoelectric conversion layer constituted by a single crystal silicon layer or poly-crystal silicon layer, and the like. As another classification, there are single-structure type solar cells each having only one layer of photoelectric conversion layer, and a tandem-structure type solar cells each comprising a plurality of photoelectric conversion layers made of materials having different band gaps (Eg) disposed in the order of Eg (top) > Eg (middle) > Eg (bottom) from the light-incident side for utilizing a wider range of solar spectrum. In such a solar cell having a tandem-structure, an amorphous silicon having a large band gap is usually used for a photoelectric conversion layer of light-incident side (top layer), and a crystal silicon such as a single crystal silicon or a poly-crystal silicon is used for the other photoelectric conversion layers. On the other hand, in a single-structure type solar cell, an amorphous silicon is used for the photoelectric conversion layer in most cases, but there are examples of using a crystal silicon in recent years.

Such a tandem-structure type solar cell is excellent in photoelectric conversion efficiency as compared with an amorphous silicon type solar cell having a single-structure. Therefore, the transparent conductive substrate as the base for such a cell is preferably one to improve the photoelectric conversion efficiency. The transparent conductive substrate for solar cells is commonly constituted by forming a transparent conductive oxide film on a substrate excellent in transparency such as glass. As the transparent conductive oxide film, a tin oxide (SnO₂) film doped with fluorine for exhibiting conductivity, is usually used.

For the purpose of improving the photoelectric conversion efficiency of solar cells, an improvement regarding transparent conductive substrates has been proposed. For example, JP-A-2001-60707 proposes a photoelectric conversion device in which an interlayer film is formed between a transparent substrate as a base and a transparent conductive film in order to reduce the average reflectivity of a photoelectric conversion unit for a light beam in a specific wavelength region.

Further, JP-A-2002-237610 pays attention to photoelectric conversion efficiency of crystal silicon type thin film layer among photoelectric conversion layers, and proposes a photoelectric conversion device wherein the haze ratio of transparent conductive substrate is specified to be at most 6.5%.

The present invention has been made to solve the above problems residing in prior arts, and it is an object of the present invention to provide a transparent conductive substrate for solar cells having high haze ratio, little variation of haze ratio over the entire surface, and excellent in light-transparency, and a method for producing such a substrate.

### DISCLOSURE OF THE INVENTION

The present invention provides in order to achieve the above object, a transparent conductive substrate for solar cells characterized in that on a substrate, a TiO₂ layer, a SiO₂ layer and a SnO₂ layer are formed in this order from the substrate side, the thickness of the SnO₂ layer is from 0.5 to 0.9 µm, and the illuminant C haze ratio is from 20 to 60%.

In the transparent conductive substrate for solar cells of the present invention, the SnO₂ layer is preferably a layer composed mainly of SnO₂ and doped with a substance for exhibiting conductivity.

In the transparent conductive substrate for solar cells of the present invention, the SnO₂ layer is preferably doped with fluorine at a concentration of from 0.01 to 4 mol% based on 1 mol of SnO₂.

In the transparent conductive substrate for solar cells of the present invention, it is preferred that irregularities are formed on the entire surface of the SnO₂ layer, and that the irregularities have a height difference of from 0.2 to 0.5 µm.

In the transparent conductive substrate for solar cells of the present invention, in terms of the illuminant C haze ratio measured at 10 points distributed over the entire surface of the substrate, the difference between the maximum value and the minimum value of the measured values of the haze ratio, is preferably at most 10%, particularly preferably at most 5%.

In the transparent conductive substrate for solar cells of the present invention, the average light transmittance in a wavelength region of from 400 to 1,200 nm is preferably more than 80%.

In the transparent substrate for solar cells of the present invention, the TiO₂ layer preferably has a thickness of from 5 nm to less than 22 nm.

In the transparent substrate for solar cells of the present invention, the SiO₂ layer preferably has a thickness of from 10 to 50 nm.

Further, the present invention provides a method for producing a transparent conductive substrate for solar cells having an illuminant C haze ratio of from 20 to 60%, characterized in that on a substrate, a TiO₂ layer, a SiO₂ layer and a SnO₂ layer having a thickness of from 0.5 to 0.9 µm, are formed in this order from the substrate side by means of an atmospheric pressure CVD method.

### BRIEF DESCRIPTION OF THE DRAWINGS

Fig. 1 is a horizontally cross-sectional view of the transparent conductive substrate for solar cells of the present invention.
Fig. 2 is a horizontally cross-sectional view of a solar cell having a tandem-structure employing the transparent conductive substrate of Fig. 1.

### EXPLANATION OF NUMERALS

1: Transparent conductive substrate for solar cells
2: Substrate
3: TiO₂ layer
4: SiO₂ layer
5: SnO₂ layer
6: First photoelectric conversion layer (amorphous silicon)
7: Second photoelectric conversion layer (crystal silicon)
8: Rear electrode layer
10: Solar cell (tandem-structure)

### BEST MODE FOR CARRYING OUT THE INVENTION

In order to improve the photoelectric conversion efficiency of a solar cell, particularly a solar cell of tandem structure, the transparent conductive substrate as an underlayer preferably has the following properties.
· Low sheet resistance
· High light transmittance
· High haze ratio
· Little variation of haze ratio over the entire transparent conductive substrate

Here, the haze ratio means a value that is scattered transmitted light quantity divided by total transmitted light quantity. As the haze ratio is high, scattering at a time of light transmission becomes large, and the optical path in the photoelectric conversion layer of the solar cell becomes long. Therefore, if it is possible to increase the haze ratio, the light absorption rate in the photoelectric conversion layer increases and the photoelectric conversion efficiency of the solar cell becomes excellent.

As a method for increasing haze ratio, there is a method of making the surface of the SnO₂ layer formed on the substrate irregular to increase scattering. Currently, it is known that it is possible to obtain a SnO₂ layer having surface irregularities by forming the layer by CVD method. Therefore, CVD method is usually used for forming a SnO₂ layer. In this case, if there is a variation in the haze ratio over entire SnO₂ layer, the photoelectric conversion efficiency of the solar cell decreases. Here, such variation of haze ratio results from unevenness of the surface irregularities of the SnO₂ layer.

JP-A-2001-59175 proposes a method of forming a tin oxide film having uniform surface irregularities on a glass substrate by using an atmospheric pressure CVD method. However, the haze ratio of the tin oxide film according to JP-A-2001-59175 is preferably from 3 to 30% on average, particularly preferably from 10 to 15%. Also with respect to the variation of the haze ratio, the variation is preferably from -20 to +20%, more preferably from -10 to +10% from the average of the haze ratio according to the document. These properties are sufficient in a case of an amorphous silicon type solar cell having a single structure. However both of the haze ratio and the variation are insufficient in a case of a solar cell having a tandem structure.

In the case of a solar cell having a tandem structure, the preferred range of haze ratio is higher than that of a solar cell of amorphous silicon type having a single structure, and is specifically at least 20%. Further, in a case where the crystallinity of crystal silicon contained in the tandem structure is high, it is necessary to make the variation of haze ratio, namely, the variation of surface irregularities as small as possible to make crystals grow uniformly. This is because the photoelectric conversion efficiency of entire solar cell can be increased by making the growth of crystals uniform.

As another method for obtaining a substrate for photoelectric conversion device having a high haze ratio, there is a method of forming a perforated underlayer between a glass substrate and a conductive film, and a substrate for photoelectric conversion device formed by this method is proposed in JP-2001-53307. However, in the substrate for photoelectric conversion proposed in JP-2001-53307, the underlayer is formed on the glass plate by a thermal decomposition oxidation reaction of a film-forming material containing chlorine, and sodium chloride generated in the underlayer film by a reaction of sodium in the glass with chlorine in the raw material disappears from the film to form pores. Therefore, it is not possible to make the distribution or the size of pores uniform. Therefore, occurrence of the variation in haze ratio of the substrate for photoelectric conversion device is inavoidable.

In order to achieve both high light transmittance and high conductivity, the substrate for photoelectric conversion device comprising a glass plate on which a high-refractive index film, a low-refractive index film and a transparent conductive film are formed in this order, is disclosed in JP-A-2001-36117. JP-A-2001-36117 shows, as a specific example of the material for the high-refractive index layer, tantalum oxide, tin oxide, titanium oxide, zinc oxide, tantalum oxide, niobium oxide, cerium oxide, zirconium oxide, silicon nitride, silicon oxynitride (SiON) or a mixture thereof, and as a material for low-refractive index film, the reference shows, for example, silicon oxide, aluminum oxide, silicon oxycarbide (SiOC) or a mixture thereof. The document specifies the ranges of refractive index and film thickness for these high-refractive index film and low-refractive index film.

However, the materials exemplified for the high-refractive index film and low-refractive index film have different refractive indexes from each other. JP-A-2001-36117 describes that the film thickness of the high-refractive index film is preferably at lest 22 nm and at most 60 nm, and the film thickness of the low-refractive index film is preferably at least 10 nm and at most 50 nm. However, among the materials exemplified for the high-refractive index film and the low-refractive index film, the materials for which the above film thickness is confirmed to be effective are only the combination of the materials shown in the Example, namely, only a case where tin oxide is used for the high-refractive index film and silicon oxide is used for the low-refractive index film.

JP-A-2001-36117 describes that a CVD method is excellent for forming these films (paragraphs [0019] to [0021] in the document), and paragraph [0026] of JP-A-2001-36117 shows specific examples of tin raw materials for forming a tin oxide film as the high-refractive index film by using a CVD method. Among these tin raw materials, tetramethyltin and tetrabutyltin are classified as hazardous materials, and thus, tin raw materials actually used are chlorides in most cases. When a tin oxide film is formed on a glass substrate by using tin chloride as a raw material and using a CVD method, sodium in the glass reacts with chlorine to precipitate sodium chloride in the interface between the glass and the tin oxide film, which may cause uneven irregularities on the interface. As described above, if such uneven irregularities are present, there is a possibility that a variation of haze ratio occurs over the entire transparent conductive substrate, which is a problem for a transparent conductive substrate having high haze ratio. Such a variation of haze ratio can be reduced by increasing the film thickness of the tin oxide film. However, if the film thickness of tin oxide film is increased, the transparency of the transparent conductive substrate is of course deteriorated.

Further, JP-A-2001-36117 mainly targets at an amorphous silicon type solar cell having a single structure as described in paragraph [0018]. As described above, a solar cell having a tandem structure has higher photoelectric conversion efficiency as compared with the amorphous silicon type solar cell having a single structure, and thus, a substrate having suitable properties for an amorphous silicon type solar cell is not always suitable for a tandem type solar cell. Specifically, as compared with a substrate for an amorphous silicon type solar cell, a substrate for tandem type solar cell is required to have higher haze ratio and smaller variation of haze ratio.

However, conventionally, there has been no transparent conductive substrate for solar cells having particularly suitable properties for a tandem type solar cell, specifically, having high haze ratio and small variation of haze ratio.

Further, JP-A-8-151235 describes that the transparency of a 4-layered film including SnO₂ formed on a glass substrate, is increased. However, there is a problem that the 4-layered film is not advantageous in productivity.

Further, JP-A-6-316442 describes as a 3-layered film, a conductive film for a touch panel having high transparency to increase visibility. However, the thickness of the conductive film for the touch panel is as thin as 0.01 to 0.02 µm to increase visibility, which is thinner than that of the present invention. Therefore, its haze ratio is at most 1%, and there is a problem that the photoelectric conversion efficiency can not be increased when it is used for a solar cell.

Further, WO-A-00/63924 pamphlet discloses a transparent substrate having a conductive multilayer antireflective film employing an ITO film as a conductive film. However, although an ITO film is usable for touch panel, it is not preferred for a solar cell since reduction of its transparency by a plasma damage at a time of forming a thin silicon film as an electric generation film on the ITO film, is larger than that of a SnO₂ film, which reduces the photoelectric conversion efficiency.

Now the present invention will be described in detail with reference to the drawings. However, the drawings are for the purpose of exemplifying, and the present invention is not limited to the embodiments shown in the drawings.

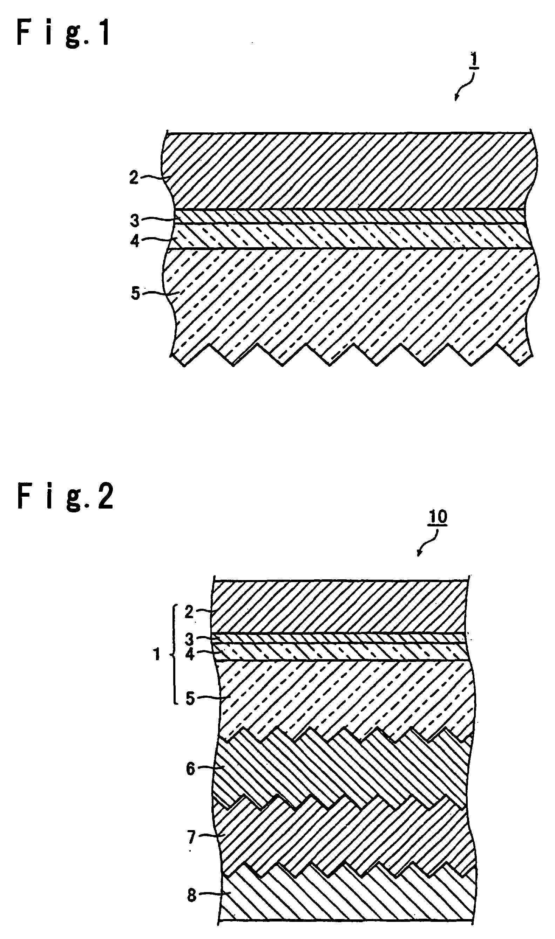

Fig. 1 is a horizontal cross-sectional view showing an embodiment of the transparent conductive substrate for solar cells of the present invention, wherein the light-incident side is shown directing upward.

As shown in Fig. 1, the transparent conductive substrate 1 for solar cells of the present invention is formed by laminating on a substrate 2, a TiO₂ layer 3, a SiO₂ layer 4 and a SnO₂ layer 5 in this order from the side of the substrate 2. In the following, each layer will be described.

In Fig. 1, the substrate 2 is a flat plate having a flat cross-sectional shape. However, in the transparent conductive substrate 1 for solar cells of the present invention, the cross sectional shape of the substrate 2 is not limited to this and is appropriately selected depending on the shape of the solar cell to be produced by employing the substrate 1. Therefore, it may be a curved plane shape or another irregular shape.

The substrate 2 usable for the transparent conductive substrate 1 for solar cells of the present invention is not particularly limited so long as it is excellent in transparency (light transparency) and mechanical strength. Specifically, a substrate 2 made of glass or plastic may, for example, be mentioned.

Among these, a substrate 2 made of glass excellent in transmittance, mechanical strength, heat-resistance and cost, is preferred. The glass material for forming the substrate 2 may be selected from the group consisting of transparent and colorless soda lime silicate glass, aluminosilicate glass, borate glass, lithium aluminosilicate glass, quartz glass, borosilicate glass, non-alkali glass and other various types of glass.

If the substrate 2 is a substrate 2 made of glass, the thickness of the substrate 2 is preferably from 0.2 to 6.0 mm. If the thickness is within this range, the substrate 2 is excellent in mechanical strength and transparency.

With respect to the transparency, the substrate 2 is preferably excellent in light-transparency in a wavelength region of from 400 to 1,200 nm. Specifically, the average light-transmittance of the substrate in the wavelength region of from 400 to 1,200 nm is preferably more than 80%, more preferably at least 85%, particularly preferably at least 90%.

Further, the substrate 2 is preferably excellent in insulation property and preferably also excellent in chemical and physical durabilities.

The TiO₂ layer 3 is a layer made of TiO₂ having higher refractive index than the substrate 2 in the wavelength region of 400 to 1,200 nm. The TiO₂ layer 3 is composed substantially of TiO₂, and the percentage of TiO₂ in the component contained in the layer is at least 90 mol%, preferably at least 95 mol%, particularly preferably at least 98 mol%.

The TiO₂ layer 3 preferably has a thickness of at least 5 nm and less than 22 nm, more preferably from 10 to 20 nm. If the thickness of TiO₂ layer 3 is at least 5 nm and less than 22 nm, the variation of illuminant C haze ratio is small over the entire transparent conductive substrate 1 for solar cells, and the light transmittance, particularly the light transmittance in the wavelength region of 400 to 1,200 nm, is high.

It is preferred that the interfaces of TiO₂ layer 3 with substrate 2 and with SiO₂ layer 4, particularly the interface with the substrate 2, is substantially flat. If the interfaces of TiO₂ layer 3 are substantially flat, it is possible to reduce the variation of illuminant C haze ratio over entire substrate of the transparent conductive substrate 1 for solar cells. The TiO₂ layer 3 preferably has an arithmetic average roughness (Rₐ) of at most 1 nm, more preferably at most 0.6 nm when the surface is measured by an atomic force microscope (AFM) before forming SiO₂ layer 4 thereon.

Here, instead of TiO₂ layer 3, it is conceivable to form a tin oxide layer (SnO₂ layer). Usually, a tin oxide layer is made of a raw material such as a chloride (SnCl₄) or a chlorine-containing organic tin (such as Sn(OC₃H₇)Cl₃) by an atmospheric pressure CVD method in many cases. In this film-forming process, chlorine in the raw material often reacts with an alkali component such as sodium in the glass to form a salt such as NaCl as a by-product material. Due to such a generation of by-product material, it is difficult to form a SnO₂ film having high flatness directly on the glass, such being not preferred.

SiO₂ layer 4 is a layer made of SiO₂ having a lower refractive index than the substrate 2 and SnO₂ layer 5 in the 400 to 1,200 nm wavelength region. The SiO₂ layer 4 is a layer composed substantially of SiO₂, and it is preferred that the proportion of SiO₂ in the component contained in the layer is at least 90%, preferably at least 95%, particularly preferably at least 98%.

The SiO₂ layer 4 preferably has a thickness of from 10 to 50 nm. If the thickness of the SiO₂ layer 4 is from 10 to 50 nm, the illuminant C haze ratio of the transparent conductive substrate 1 for solar cells is high, and the variation of illuminant C haze ratio is small over the entire substrate 1. The thickness of the SiO₂ layer 4 is preferably from 20 to 40 nm, more preferably from 20 to 35 nm.

Also with respect to the SiO₂ layer 4, it is preferred that the interfaces of SiO₂ layer 4 with TiO₂ layer 3 and with SnO₂ layer 5 are substantially flat. If the interfaces of the SiO₂ layer 4 are substantially flat, crystals of SnO₂ layer 5 to be laminated thereon uniformly grow over the substrate, and it is possible to suppress the variation of illuminant C haze ratio over the entire substrate of the transparent conductive substrate 1 for solar cells as a result. The SiO₂ layer 4 preferably has an arithmetic average roughness (Rₐ) of at most 1 nm, more preferably at most 0.6 nm when the surface is measured by an atomic force microscope (AFM) before a SnO₂ layer 5 is formed thereon.

Here, in a case where the substrate 2 is made of glass containing sodium such as a soda lime silicate glass, or a low-alkali containing glass, the SiO₂ layer 4 functions also as an alkali-barrier layer for minimizing diffusion of alkali components into the SnO₂ layer 5 from the substrate 2 made of glass.

The transparent conductive substrate 1 for solar cells of the present invention comprises a TiO₂ layer 3 having a refractive index in the 400 to 1,200 nm wavelength region higher than that of the substrate 2, and a SiO₂ layer 4 having the above refractive index lower than SnO₂ layer 5, formed in this order between the substrate 2 and the SnO₂ layer 5. Therefore, the influence of the difference of the refractive indexes between the substrate 2 and the SnO₂ layer 5, specifically, the reflection loss of incident light due to the difference of the refractive indexes, can be reduced, whereby the light transmittance, particularly the light transmittance in the 400 to 1,200 nm wavelength region, is high.

The SnO₂ layer 5 has a thickness of from 0.5 to 0.9 µm. The thickness of the SnO₂ layer 5 is preferably from 0.6 to 0.8 µm. If the thickness of the SnO₂ layer 5 is from 0.6 to 0.8 µm, the illuminant C haze ratio of the transparent conductive film 1 for solar cells is particularly high, the variation of the illuminant C haze ratio over the entire substrate 1 is particularly small, the light transmittance, particularly the light transmittance in the 400 to 1,200 nm wavelength region, is particularly high, and the conductivity of the SnO₂ layer 5 is particularly excellent. Here, the thickness of the SnO₂ layer 5 means a thickness including the surface irregularities to be described later.

The SnO₂ layer 5 preferably has irregularities formed evenly over the entire surface. The irregularities preferably have a height difference (height difference between protrusions and recesses) of from 0.2 to 0.5 µm, more preferably from 0.2 to 0.3 µm. Further, the interval between the protrusions (the distance between the peaks of neighboring protrusions) is preferably from 0.3 to 0.75 µm, more preferably from 0.3 to 0.45 µm.

If irregularities are formed on the surface of the SnO₂ layer 5, the haze ratio of the transparent conductive substrate 1 for solar cells is increased by light-scattering. Further, if the irregularities are uniformly formed over the entire surface of the SnO₂ layer 5, the variation of the haze ratio is small over the entire substrate 1.

The SnO₂ layer 5 is preferably composed mainly of SnO₂, and doped with a substance for providing conductivity. Here, in the SnO₂ layer 5, the percentage of the SnO₂ layer 5 contained in the layer is preferably at least 90 mol%, more preferably at least 95 mol%. As the material to be doped with, fluorine or antimony can be used, and among these, fluorine is preferred. More specifically, the SnO₂ layer 5 is preferably doped with 0.01 to 4 mol% of fluorine based on 1 mol of SnO₂.

The conductive electron density of the SnO₂ layer 5 is improved by the substance for providing conductivity, doped in the layer. The SnO₂ layer 5 preferably has a conductive electron density within a range of from 5×10¹⁹ to 4×10²⁰ cm⁻³, more preferably within a range of from 1×10²⁰ to 2×10²⁰ cm⁻³. If the conductive electron density of the SnO₂ layer 5 is within the above range, the SnO₂ layer shows little light absorption and is highly transparent. Further, since the layer has high durability against reactive hydrogen species, the transparency is not impaired even by conducting a hydrogen plasma radiation commonly applied for forming a thin film silicon type solar cell.

With respect to conductivity, the SnO₂ layer 5 preferably has a sheet resistance of from 8 to 20 Ω/□, more preferably from 8 to 12 Ω/□.

The transparent conductive substrate for solar cells of the present invention has a high illuminant C haze ratio (JIS K7105-1981) since it has the above construction. Specifically, the substrate has an illuminant C haze ratio of from 20 to 60%. The illuminant C haze ratio is preferably from 20 to 40%. An illuminant C haze ratio of from 20 to 60% is preferred for reducing the variation of illuminant C haze ratio over the entire substrate.

Further, the transparent conductive substrate for solar cells of the present invention shows little variation of illuminant C haze ratio over the entire substrate. Specifically, the difference between the maximum and the minimum haze ratios is at most 10%, among the illuminant C haze ratios measured at 10 points in the longitudinal direction of the substrate with intervals of 10 mm. The difference is preferably at most 5%, particularly preferably at most 3%, more particularly preferably at most 2%.

Further, the transparent conductive substrate for solar cells of the present invention is excellent in light transmittance, particularly the light transmittance in the 400 to 1,200 nm wavelength region. Specifically, the average light transmittance is preferably at least 80% in the 400 nm to 1,200 nm wavelength region. The average light transmittance is preferably at least 83%, more preferably at least 86%.

The transparent conductive substrate for solar cells of the present invention is preferably produced by using an atmospheric pressure CVD method. From now, a method for producing the transparent conductive substrate for solar cells of the present invention using an atmospheric pressure CVD method, will be described with suitable examples. Here, the transparent conductive substrate for solar cells of the present invention may be produced by any method so long as the above construction can be obtained, and is not limited to the method described below. Here, since it is difficult to obtain SnO₂ having high crystallinity by a sputtering method, the SnO₂ formed by the sputtering method has lower haze ratio than that of SnO₂ formed by an atmospheric pressure CVD method and it is difficult to obtain SnO₂ having high photoelectric conversion rate by the sputtering method. For this reason, the sputtering method is not preferred.

In the following, a suitable example of the production method for a substrate with a transparent conductive oxide film of the present invention using an atmospheric pressure CVD method, will be described. However, the production method of the present invention is not limited to this.

A substrate made of glass moving in a predetermined direction is heated at a high temperature (for example, 500°C) using a belt-conveyor furnace. In this state, tetraisopropoxytitanium as a raw material for TiO₂ layer is vaporized, mixed with nitrogen gas and blown against the substrate surface. Thus, a TiO₂ layer is formed on the substrate surface by an atmospheric pressure CVD method.

Then, in a state that the substrate having a surface on which TiO₂ layer is formed is maintained at a high temperature, a silane gas as a material for SiO₂ layer is blown against the base surface. Thus, a SiO₂ layer is formed on the TiO₂ layer by the atmospheric pressure CVD method.

Further, the substrate on which the TiO₂ layer and the SiO₂ layer are formed is heated (for example, at 520°C), and tin tetrachloride, water and hydrogen fluoride are blown against the surface of substrate at the same time. Thus, a SnO₂ layer doped with fluorine is formed on the SiO₂ layer by the atmospheric pressure CVD method. The SnO₂ layer formed by this process has uniform irregularities over the entire surface.

Here, tin tetrachloride and water are preferably blown against the substrate in a state of a gas containing both of them, and it is preferred that against the substrate moving in a predetermined direction, gases having different mixture ratios of tin tetrachloride to water, are blown from plural positions at an upstream side and a downstream side in the moving direction. Here, the gas at the upstream side in the moving direction of the substrate has a concentration of the water to tin tetrachloride lower than that of the gas at the downstream side. This step is preferred for producing a transparent conductive substrate for solar cells having an illuminant C haze ratio of at least 20%.

The transparent conductive substrate for solar cells of the present invention may be employed for a wide range of solar cells irrespective of the difference in the material of the photoelectric conversion layer such as amorphous silicon type or crystalline silicon type, or a difference in the structure such as a single structure or a tandem structure. Therefore, the substrate can be employed for an amorphous silicon type solar cell having a single structure. However, it is particularly preferred to use the transparent conductive substrate for solar cells of the present invention for a solar cell having a tandem structure which is excellent in photoelectric conversion efficiency, because of the characteristic of the substrate that the illuminant C haze ratio is high, the variation of the illuminant C haze ratio is small over the entire surface, and the light transmittance, particularly the light transmittance in the 400 to 1,200 nm wavelength region, is high.

Fig. 2 is a horizontally cross-sectional view showing an example of a solar cell having a tandem structure employing the transparent conductive substrate for solar cells of the present invention.

A solar cell 10 shown in Fig. 2 is constituted by a transparent conductive substrate 1, a first photoelectric conversion layer 6, a second photoelectric conversion layer 7 and a rear electrode layer 8. This is a normal construction of a thin film solar cell having a tandem structure. Here, the transparent conductive substrate 1 is a transparent conductive substrate 1 for solar cells of the present invention comprising a substrate 2 and a TiO₂ layer 3, a SiO₂ layer 4 and a SnO₂ layer 5 formed on the substrate 2 in this order from the side of the substrate 2.

Into the solar cell 10 of Fig. 2, light is incident from the side of transparent conductive substrate 1. Each of the first photoelectric conversion layer 6 and the second photoelectric conversion layer 7 has a pin structure in which a p-layer, an i-layer and an n-layer are laminated in this order from the light incident side. Here, in the first photoelectric conversion layer 6 in the light incident side, the p-layer, the i-layer and the n-layer are made of amorphous silicon having a large band gap Eg. On the other hand, in the second photoelectric conversion layer located at more downstream side for the incident light, a p-layer, an i-layer and an n-layer are made of a crystal silicon such as a single crystal silicon, a poly-crystal silicon or a microcrystal silicon. Here, although a structure having only one layer of the second photoelectric conversion layer 7 is shown, a plurality of the second photoelectric conversion layers 7 having different band gaps Eg may be laminated, and such a structure is rather preferred. In the case of forming a plurality of the second photoelectric conversion layers 7, the second photoelectric conversion layers 7 are laminated so that their band gaps Eg become smaller from the light-incident side to the downstream side.

Light incident into the solar cell 10 is absorbed in the first photoelectric conversion layer 6 and the second photoelectric conversion layer 7, more specifically, in the respective i-layers of these two layers and generates an electromotive force by a photoconduction effect. The electromotive force thus generated is taken out to the outside using a transparent conductive film of the transparent conductive substrate 1, namely, the SnO₂ layer 5 and the rear electrode layer 8 as electrodes. Since the solar cell 10 has the first photoelectric conversion layer and the second photoelectric conversion layer 7 having different band gaps Eg, a wide range of solar energy spectrum can be efficiently utilized and thus the solar cell 10 is excellent in photoelectric conversion efficiency. This effect can be amplified by providing a plurality of the second photoelectric conversion layers 7 having different band gaps Eg from each other and laminating these plurality of the second photoelectric conversion layers 7 so that the Eg becomes smaller from the light incident side towards the downstream side.

The solar cell of Fig. 2 may have another layer, for example, a contact-improvement layer between the rear electrode layer 8 and the second photoelectric conversion layer 7. By providing the contact-improvement layer, the contact between the rear electrode layer 8 and the second photoelectric conversion layer 7 is improved.

A tandem type solar cell as shown in Fig. 2 is excellent in photoelectric conversion efficiency as compared with a conventional single type amorphous silicon type solar cell. Therefore, the transparent conductive substrate to be used preferably has a property improving the photoelectric conversion efficiency. Therefore, the transparent conductive substrate preferably has a high haze ratio and shows little variation of the haze ratio over the entire substrate.

Further, it is necessary that the transparent conductive substrate has a high light transmittance. In a case of tandem type solar cell, the wavelength region of light to be utilized is wider than that of a single type amorphous silicon type solar cell. Specifically, in a case of the single type amorphous silicon type solar cell, it is sufficient that the substrate has a high light transmittance within the 300 to 800 nm wavelength region. However, in the case of the tandem type solar cell, the substrate is required to have a high light transmittance in a wider wavelength region, specifically, in a region of from 400 to 1,200 nm wavelength.

The transparent conductive substrate for solar cells of the present invention has a high haze ratio, a small variation of the haze ratio over the entire substrate and a high light transmittance, specifically, a high light transmittance within the region of from 400 to 1,200 nm wavelength, whereby it is possible to improve the photoelectric conversion efficiency when it is used for a tandem type solar cell.

The tandem type solar cell shown in Fig. 2 can be produced by a conventional method. Namely, it is produced by forming the first and the second photoelectric conversion layers 6 and 7 on the transparent conductive substrate 1 by using a plasma CVD method, and by forming the rear electrode layer 8 by using a sputtering method. Here, in a case of forming the contact-improvement layer between the second photoelectric conversion layer 7 and the rear electrode layer 8, a sputtering method may be used.

### EXAMPLES

From now, the present invention is further specifically described using Examples. However, the present invention is not limited to these Examples.

### EXAMPLE 1

### (1) Preparation of transparent conductive substrate for solar cells

A substrate (30 cm × 40 cm × 4 mm) made of a soda lime silicate glass was prepared for a base. It was sufficiently cleaned, and TiO₂ layer of 5 nm thick, a SiO₂ layer of 32 nm thick and a SnO₂ layer of 0.5 µm thick doped with fluorine were formed on the substrate in this order from the side of the substrate.

Specifically, it was prepared by the following procedure. The substrate was previously heated at 500°C in a belt conveyor furnace. Against the substrate moving in a predetermined direction, tetraisopropoxytitanium as a source gas for TiO₂ layer was blown to form a TiO₂ layer on the surface of the substrate. The tetrapropoxytitanium was vaporized by putting it in a bubbler tank maintained at 90°C and supplying nitrogen at a rate of 5 L/min from a bottle.

Then, 0.1 L/min of silane gas and 5 L/min of oxygen gas were blown against the surface of the TiO₂ layer formed on the substrate to form a SiO₂ layer.

Further, the substrate on which the SiO₂ layer was formed, was heated at 520°C and a gas containing tin tetrachloride, water and hydrogen fluoride at the same time was blown against the base to form a SnO₂ layer doped with 3.5 mol% of fluorine. Here, tin tetrachloride was vaporized by putting it in a bubbler tank maintained at 45°C and introducing nitrogen from a bottle. Water was supplied from a boiler maintained at at least 100°C. Hydrogen fluoride gas was vaporized from a bottle heated at 40°C. A gas as a mixture of these was blown at two positions, namely, at the upstream side and the downstream side with respect to the moving direction of the substrate by using two injectors. The mixture ratio of tin tetrachloride to water was tin tetrachloride : water = 1 : 20 at the first injector in the upstream side, and it was tin tetrachloride : water = 1 : 100 at the second injector in the downstream side. By this method, a SnO₂ layer having fine irregularities formed evenly on the entire surface, was formed.

Thus, a transparent conductive substrate for solar cells comprising a substrate made of glass and a TiO₂ layer, a SiO₂ layer and a SnO₂ layer formed on the substrate in this order from the base side, was prepared.

### (2) Evaluation of physical properties

With respect to the transparent conductive substrate for solar cells thus obtained, the following evaluations of physical properties were carried out. The results are shown in Table 1.

### THICKNESS OF LAYERS (TiO₂ LAYER, SiO₂ LAYER AND SnO₂ LAYER)

With respect to the TiO₂ layer and the SiO₂ layer, the thickness was measured by a probe-contact type surface-roughness meter (DEKTAK 3030 manufactured by Ulvac) after forming each layer. With respect to the SnO₂ layer, after forming all layers, only a part of the SnO₂ layer was covered with a mask and etched with HCl : Zn to form a step, and the height of the step was measured by the above surface-roughness meter to obtain the thickness.

### FLUORINE CONCENTRATION IN THE SnO₂ LAYER

The fluorine concentration in the SnO₂ layer was obtained by dissolving the SnO₂ layer in a hydrochloric acid containing zinc, and carrying out a quantitative analysis by a gas chromatography. Here, the fluorine concentration in Table 1 is shown by mol% to SnO₂.

### ILLUMINANT C HAZE RATIO AND THE VARIATION OF ILLUMINANT C HAZE RATIO OVER THE ENTIRE SUBSTRATE

At 10 positions distributed over the entire substrate, the illuminant C haze ratio was measured at an interval of 10 mm in the longitudinal direction of the substrate by a haze meter (TC-H III, manufactured by TOKYO DENSHOKU CO., LTD.). The average value of the haze ratios obtained was designated as illuminant C haze ratio of the substrate. Further, the difference between the maximum and minimum values of the haze ratio obtained, was designated as the variation of the illuminant C haze ratio over the entire substrate.

### AVERAGE LIGHT TRANSMITTANCE (400 nm TO 1,200 nm)

The average value of spectral transmittance within the wavelength region of from 400 nm to 1,200 nm, was measured by a spectrophotometer (U-3410 self-recording spectrophotometer, manufactured by HITACHI) employing an integrating sphere, and the decrease of the measured transmittance due to haze was corrected by a known method (a measurement method of measuring the transmittance of a conductive film in a state that its irregular surface is in contact with a quartz glass substrate and methane diionide (CH₂I₂) is sandwiched between them to prevent decrease of measured transmittance by the surface irregularities of the conductive film)(described in e.g. Jpn. J. Appl. Phys. 27 (1988) 2053, or Asahi Glass Res. Res. Rep. 127 (1987) 13) to calculate the average light transmittance.

### SHEET RESISTANCE

The sheet resistance was measured by a four-terminal method. The substrate prepared was cut into about 3 cm square, paired electrodes of 3 cm long were respectively attached to two opposite sides of the cut substrate so that the electrodes were in parallel with each other and the distance between the electrodes was 3 cm. Then, the resistance between the electrodes (sheet resistance) was measured by a tester.

### HEIGHT DIFFERENCE OF SURFACE IRREGULARITIES OF SnO₂ LAYER

The height difference of surface irregularities of the SnO₂ layer was measured by using a scanning electron microscope (SEM) (JSM-820, manufactured by JEOL Ltd.), to obtain the average of the height differences of 10 irregularities randomly sampled. By using this result, uniformity of the irregularities was evaluated under the following standards:
Variation of height difference of the irregularities exceeds ±10%: The irregularities are uneven and the variation of the size of protrusions is large.
Variation of height difference of the irregularities is within ±10%: The irregularities are relatively uniform.
Variation of height difference of the irregularities is within ±5%: The irregularities are uniform.

### EXAMPLES 2 TO 9

Transparent conductive substrates for solar cells were prepared in the same procedure as Example 1 except that the thicknesses of TiO₂ layer, SiO₂ layer and SnO₂ layer and the fluorine concentration were changed to the values shown in Table 1, and evaluation of physical properties was carried out. The results are shown in Table 1.

### COMPARATIVE EXAMPLES 1 TO 3

Transparent conductive substrates for solar cells were prepared in the same procedure as Example 1 except that the thicknesses of SiO₂ layer and SnO₂ layer and the fluorine concentration were changed to the values shown in Table 1 and that the TiO₂ layer was not formed on the base made of glass, and evaluation of physical properties were carried out. The results are shown in Table 1.

### COMPARATIVE EXAMPLES 4 TO 7

In the same manner as Comparative Examples 1 to 3, transparent conductive substrates were prepared so that the thicknesses of SiO₂ layer and SnO₂ layer and the fluorine concentration indicated the values shown in Table 1, and that no TiO₂ layer was formed on the base made of glass. Here, at a time of forming the SnO₂ layer, the source gas (containing tin tetrachloride, water and hydrogen fluoride) was blown against the substrate surface without changing the mixture ratio of tin tetrachloride to water at the upstream side and downstream side in the moving direction of the substrate (tin tetrachloride : water = 1 : 100 both at the upstream side and downstream side).

### COMPARATIVE EXAMPLE 8

A transparent conductive substrate for solar cells was prepared in the same procedure as Example 1 except that the thicknesses of TiO₂ layer and SnO₂ layer and the fluorine concentration were changed to the values shown in Table 1 and that no SiO₂ layer was formed, and evaluation of physical properties was carried out. The results are shown in Table 1.

Here, the arithmetic surface roughness (Ra) of the TiO₂ layer before forming SiO₂ layer was Ra=0.3 nm (when the thickness of TiO₂ layer was 7 nm), Ra=0.6 nm (when the thickness of TiO₂ layer was 11 nm) and Ra=1.4 nm (when the thickness of TiO₂ layer is 18 nm). Here, the method for forming TiO₂ layer was the same as the method of Example 1 except for the thickness.

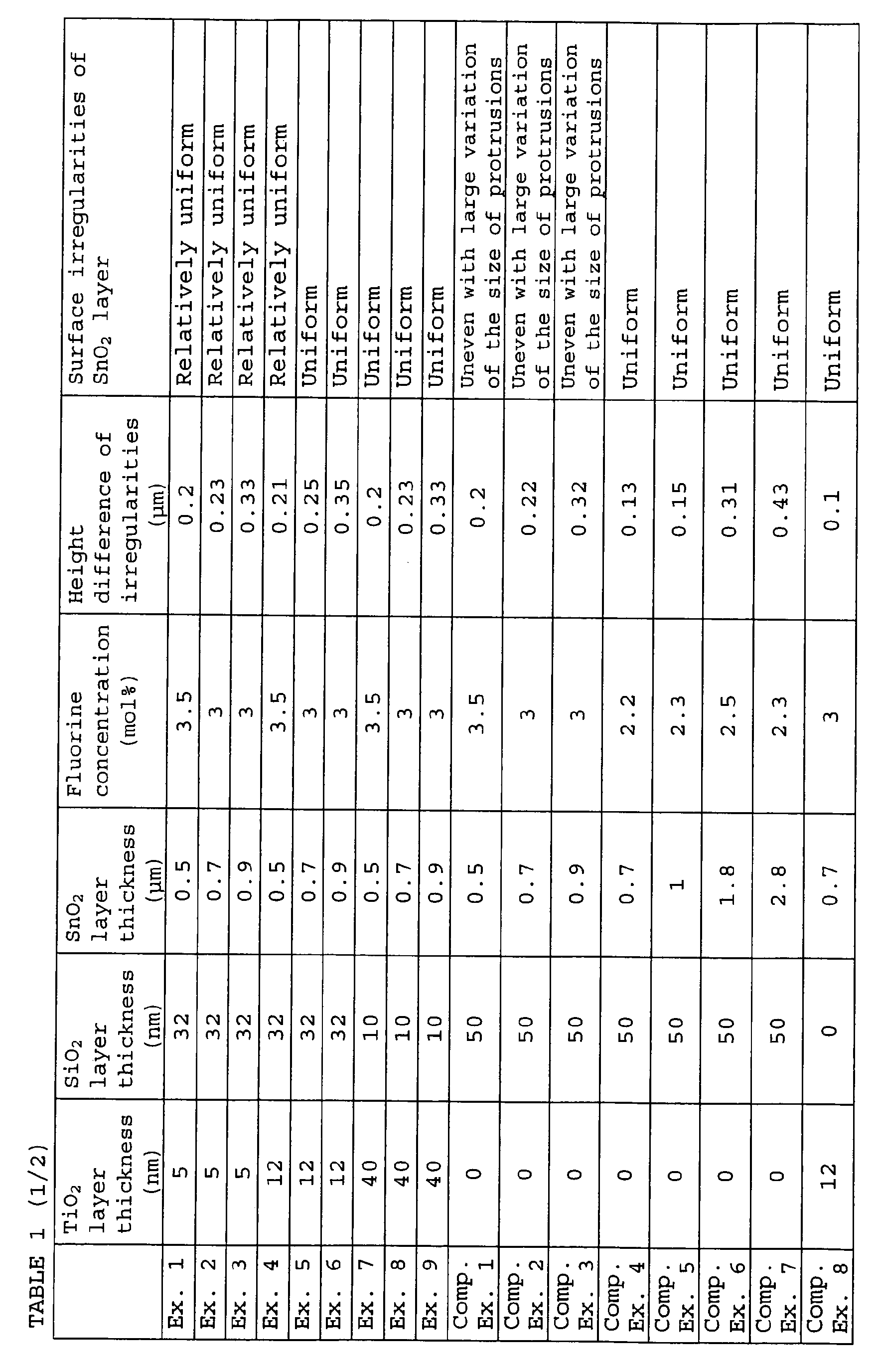

**TABLE 1 (2/2)**

| | Illuminant C haze ratio (%) | | Average light transmittance 400 to 1,200 nm (%) | Sheet resistance (Ω/□) |
|---|---|---|---|---|
| | Average | Variation | | |
| Ex. 1 | 20 | 4 | 89 | 12 |
| Ex. 2 | 25 | 4 | 88 | 10 |
| Ex. 3 | 45 | 4 | 86 | 8 |
| Ex. 4 | 20 | 4 | 91 | 12 |
| Ex. 5 | 25 | 3 | 89 | 10 |
| Ex. 6 | 45 | 2 | 87 | 8 |
| Ex. 7 | 20 | 2 | 80 | 12 |
| Ex. 8 | 25 | 2 | 79 | 10 |
| Ex. 9 | 45 | 2 | 78 | 8 |
| Comp. Ex.1 | 20 | 6 | 89 | 12 |
| Comp. Ex. 2 | 25 | 7 | 87 | 10 |
| Comp. Ex. 3 | 45 | 7 | 85 | 8 |
| Comp. Ex.4 | 7 | 3 | 87 | 11 |
| Comp. Ex. 5 | 15 | 3 | 84 | 8 |
| Comp. Ex. 6 | 42 | 3 | 76 | 5 |
| Comp. Ex. 7 | 65 | 3 | 75 | 4 |
| Comp. Ex. 8 | 7 | 2 | 78 | 20 |

### INDUSTRIAL APPLICABILITY

The transparent conductive substrate for solar cells of the present invention has characteristics that it has a high illuminant C haze ratio, a small variation of the illuminant C haze ratio over the entire substrate, and a high light transmittance, particularly a high light transmittance within a region of from 400 to 1,200 nm wavelength. Further, since the substrate employs a TiO₂ layer, transparency can be maintained with smaller variation of haze ratio. By these characteristics, since the substrate can efficiently utilize solar light and significantly improve the photoelectric conversion efficiency, the substrate is useful for a solar cell excellent in photoelectric conversion efficiency, particularly for a solar cell having a tandem structure more excellent in photoelectric conversion efficiency than an amorphous silicon type solar cell having a single structure.

## Claims

1. A transparent conductive substrate for solar cells **characterized in that** on a substrate, a TiO₂ layer, a SiO₂ layer and a SnO₂ layer are formed in this order from the substrate side, the thickness of the SnO₂ layer is from 0.5 to 0.9 µm, and the illuminant C haze ratio is from 20 to 60%.

2. The transparent conductive substrate for solar cells according to Claim 1, wherein in terms of an illuminant C haze ratio measured with a haze meter over the entire surface of the substrate, the difference between the maximum value and the minimum value of the measured values of the haze ratio, is at most 10%.

3. The transparent conductive substrate for solar cells according to Claim 1 or 2, wherein the TiO₂ layer has a thickness of from 5 nm to less than 22 nm.

4. The transparent conductive substrate for solar cells according to Claim 1, 2 or 3, wherein the arithmetic average roughness (Rₐ) of the TiO₂ layer is at most 1 nm.

5. The transparent conductive substrate for solar cells according to any one of Claims 1 to 4, wherein the SiO₂ layer has a thickness of from 10 to 50 nm.

6. The transparent conductive substrate for solar cells according to any one of Claims 1 to 5, wherein the arithmetic average roughness (Rₐ) of the SiO₂ layer is at most 1 nm.

7. The transparent conductive substrate for solar cells according to any one of Claims 1 to 6, wherein the SiO₂ layer is substantially flat at the interface with the SnO₂ layer.

8. The transparent conductive substrate for solar cells according to any one of Claims 1 to 7, wherein irregularities are formed on the surface of the SnO₂ layer, and the irregularities have a height difference of from 0.2 to 0.5 µm.

9. The transparent conductive substrate for solar cells according to Claim 8, wherein the pitch between protrusions in the irregularities is from 0.3 to 0.75 µm.

10. The transparent conductive substrate for solar cells according to any one of Claims 1 to 9, wherein the SnO₂ layer is a layer composed mainly of SnO₂ and doped with a substance to provide electrical conductivity.

11. The transparent conductive substrate for solar cells according to any one of Claims 1 to 10, wherein the conductive electron density of the SnO₂ layer is from 5×10¹⁹ to 4×10²⁰ cm⁻³.

12. The transparent conductive substrate for solar cells according to any one of Claims 1 to 11, wherein the SnO₂ layer has a sheet resistance of from 8 to 20 Ω/□.

13. The transparent conductive substrate for solar cells according to any one of Claims 1 to 12, wherein the average light transmittance in a wavelength region of from 400 to 1200 nm is at least 80%.

14. The transparent conductive substrate for solar cells according to any one of Claims 1 to 13, wherein the TiO₂ layer, the SiO₂ layer and the SnO₂ layer are formed by a CVD method.

15. A solar cell employing the transparent conductive substrate for solar cells as defined in any one of Claims 1 to 14.

16. A solar cell having a tandem structure employing the transparent conductive substrate for solar cells as defined in any one of Claims 1 to 14.

17. A method for producing a transparent conductive substrate for solar cells having an illuminant C haze ratio of from 20 to 60%, **characterized in that** on a substrate, a TiO₂ layer, a SiO₂ layer and a SnO₂ layer having a thickness of from 0.5 to 0.9 µm, are formed in this order from the substrate side by means of an atmospheric pressure CVD method.
